# EUROPEAN PATENT SPECIFICATION

(11) **EP 2 484 956 B1**
(45) Date of publication and mention of the grant of the patent: **04.06.2014**
(21) Application number: 12152461.5
(22) Date of filing: 25.01.2012
(51) Int. Cl.: F21S 4/00, F21V 29/00, B29C 35/08, F21Y 101/02

(54) **LED, OLED, EL light sources encapsulated by coextrusion in a silicone elastomer crosslinkable without heat with UV rays comprising heat-conductive materials, and the preparation process thereof**
Mittels Coextrusion in ohne Wärme mit UV-Strahlung vernetzbarem Silikonelastomer verkapselte LED-, OLED-, EL-Lichtquellen mit wärmeleitfähigen Materialen und Herstellungsverfahren dafür
DEL, OLED, sources lumineuse EL encapsulées par coextrusion dans un élastomère en silicone réticulable sans chaleur par rayons UV comportant des matériaux conducteurs de chaleur et leur procédé de préparation

(30) Priority: 04.02.2011 IT MI20110164
(43) Date of publication of application: 08.08.2012
(73) Proprietor: Luxall S.r.l., 20124 Milano (IT)
(72) Inventor: Ripa, Alberto, 20131 Milano (IT); Passerini, Marco, 25057 Sale Marasini (Brescia) (IT); Lo Cicero, Federico, 20090 Segrate (Milano) (IT); Cavalieri, Fabio, 20061 Carugate (Milano) (IT)
(74) Representative: Petruzziello, Aldo

(56) References cited:
- EP-A2- 0 760 448
- WO-A1-98/23896
- WO-A1-2005/106320
- WO-A1-2007/041805
- WO-A1-2009/136861
- WO-A2-2009/027133
- DE-A1-102008 009 808
- US-A1- 2010 277 914
- US-B1- 6 186 645

## Description

The present invention relates to flexible, elastic and bendable lighting elements, obtained through coextrusion of a silicone elastomer, crosslinkable without heat, on LED, OLED, EL light sources supported by profiles in heat-conductive materials.

More particularly the invention relates to flexible lighting elements, obtained through coextrusion of a silicone elastomer, crosslinkable without heat by means of UV rays, on LED, OLED, EL light sources, and their optics, supported by elastic and flexible profiles in heat-conductive silicone elastomer.

LED (*light emitting diode*) light sources of various shapes, types (SMD, DIP, etc.), powers and supplies, are extensively widespread sources of light thanks to their numerous advantages from the lighting engineering viewpoint, including: high durability, high yield, safe operation as often at very low voltage, possibility of miniaturisation of the lighting appliances, lack of sensitivity to vibrations, eco-compatibility thanks to the lack of mercury, possibility in some models of dynamic effects (RGB, RGBW colour change, etc.).

The new OLED (*organic light emitting diode*) light sources are at present little used in the field of lighting engineering on account of their high cost due above all to the recent development and to the current production process. They do however offer interesting advantages, including: low supply voltage, optimal contrast, brilliancy of the colours, possibility of creating flexible supports.

EL (*electroluminescent*) light sources are used more, given the low light emission, for back lighting effects or signs. They have some interesting advantages, including: minimal thicknesses, flexibility, mechanical resistance to vibrations, uniformity of light, almost zero emission of heat and the possibility of being made in any shape.

Very often these sources, in particular LED ones, are mounted on flexible supports, of various types and lengths, also holding the relative electrical contacts and circuits, creating flexible lighting strips (LED strips) suitable for being applied to elements or surfaces of different geometries.

When said flexible lighting strips are used outdoors or when it is required for them to belong to a specific IP protection class necessary for a certain use, they are covered with a sheath of an appropriate plastic, rigid or flexible material.

The flexible coverings (sheaths) used to date have a base of plasticised polyvinyl chloride (PVC) and of RTV (room temperature vulcanisation) silicone elastomer.

The use of plasticised PVC **or other thermoplastic polymers** allows the covering of the light sources by direct coextrusion, as a continuous process. See, for example, the patent US 6,186,645, **and** EP 760448**. However the polymers of** EP 760448 **are not flexible.**

Plasticised PVC does however have limits in the temperature of use (typically from - 20°C up to +60°C), contains plasticisers, and is not advisable for uses in an outside area (outdoors) with sharp temperature change or with particular rigid or torrid climates.

RTV silicone elastomers are low-viscosity materials, non-extrudable, which vulcanise at ambient temperature or a little higher. Compared to plasticised PVC they have the advantage of being usable in a wider temperature range (typically from -60°C up to +200°C), do not contain plasticisers, are very transparent, have excellent resistance to atmospheric agents and to ultraviolet rays and are for this reason perfectly suitable for uses both in inside and outside areas (indoors and outdoors).

However the low viscosity of the RTV silicones entails their use only by pouring or **potting or casting** in appropriate moulds and not by direct coextrusion, as a continuous process **(see for example** DE 102008009808**).** This limits the production of said elements covered with this material to a few metres at a time, particularly those of the lighting profile or strip type. Moreover, whenever it is required to change the shape of the section of the covering, it is necessary to make a special mould. The use of moulds is necessary since these liquid silicone elastomers tend to deform and not to maintain the shape given to them during the time of crosslinking.

Solid silicone elastomers also exist, characterised by greater viscosity, which makes their extrusion very easy, such as HTV (high temperature vulcanisation) silicones. These materials, however, are crosslinkable in short lengths of time - necessary for imparting to them any shape (parts, for example, such as fins and feet), blocking it before it can deform - only at very high temperatures (higher than 200°C) which the lighting strips could not withstand. Direct covering by coextrusion as a continuous process of lighting strips with HTV silicone elastomers is not therefore possible, in particular imparting to this covering in HTV silicone elastomer any shape and geometry.

The use of said HTV silicones for coverings of lighting strips could be possible if a process were used which provides for the preparation, first, of a profile (sheath) of adequate section by means of extrusion of the HTV silicone in a continuous process, subsequently inserting manually the lighting strip in the profile and sealing all this with a silicone sealant at ambient temperature or slightly higher. However this sequence, apart from its complexity, does not allow perfect encapsulation of the lighting strip and the prevention of trapping of air bubbles. The air bubbles are to be avoided in that they may alter the optical dot-shaped effect of the LED sources or uniform effect of the OLED and EL sources.

The disadvantage of said lighting strips covered by the sheath is that of having a low dissipation of the heat generated during the functioning of the lighting strips (in particular the LED and OLED ones), in particular when inserted in a section bar or frame and/or when high-power light diodes are present which rapidly generate heat. This entails a reduction in the life of the light sources since the light-emitting diodes, being based on semiconductor materials, do not guarantee their performances and longevity at temperatures normally higher than 100°C on the point of attachment. Additionally, since the covered lighting strips are commonly applied to surfaces by means of double-sided adhesives, the adhesion could be undermined following hardening or ageing of the same adhesive.

Moreover, since very often said covered lighting strips are attached both to the interior and to the exterior of buildings, it is desirable for them to be able to exert also an action of water and/or air sealing when inserted in a section bar or frame,

It is moreover particularly desirable to have available LED lighting elements of any shape, in order to obtain also aesthetic value, and provided with such flexibility and elasticity as to be able to be appropriately bent.

The patent application WO 2007/041805 describes lighting means containing LED lights formed by a first internal body in HTV silicone with elongated and parallel grooves where electric conductors are housed which project in part therefrom to allow the LED sources to be welded thereon. Externally, to cover everything, a sheath in silicone is provided, crosslinkable by a thermal process at a lower temperature compared to that of the internal body in order to avoid the damage of the welds on the conductors. The patent application WO 2007/041805 in any case refers to "LED-cables" and not to "LED strips", does not provide a heat dissipating part, and does not allow imparting to the sheath in HTV silicone any shape and geometry, for the reasons stated previously.

US 2010/277914 describes a lighting apparatus, made up of a rigid metal profile with ribbings, of length up to 2 m, provided with a groove wherein a LED strip is placed and later a non-elastic polymeric material poured, such as a crosslinkable resin or plastic, to cover said LED strip, This LED lighting apparatus, however, is neither flexible nor elastic nor bendable given the use of a metal section bar as support for the LED strip and the use of a plastic or resin as covering of the same.

The object of the present invention is to provide lighting elements that are flexible, transparent or with special optical effects, containing light sources, a) which overcome, at least in part, the disadvantages of the prior art; b) which are elastic and can be appropriately bent; c) which can be prepared in any length and shape required by the users; d) which have a covering having any shape and/or geometry to obtain also a high aesthetic value; e) which can be used in a wide range of temperatures and in any environmental situation without any deterioration; f) and which have a high dissipation of the heat in order to obtain a high duration even when high-power light diodes are present.

A further object is that of providing these flexible lighting elements which can be made in a continuous process without undergoing damage of the lights incorporated therein, and which can also be mounted without the use of double adhesives. Moreover, another object of the present invention is that of providing these flexible lighting elements which can be made with a simple process, with short production times, which does not entail the presence of air bubbles inside the strip.

These objects are achieved by the covered lighting strips in accordance with the invention having the features listed in the annexed independent claim 1.

Advantageous embodiments of the invention are disclosed by the dependent claims.

The object of the present invention are elastic and flexible lighting elements formed by a lighting strip of LED, OLED, EL light sources covered by a sole covering of whatsoever shape, in silicone elastomer material (also defined as silicone rubber), extrudable, also in a continuous process, and crosslinkable without heat by means of UV rays (i.e. without heat supply as takes place for example in IR ovens, in hot air ovens, in UHF ovens, in molten salt baths, in autoclave).

Said lighting strip also rests on a heat-conductive support, preferably of the silicone type or of another kind, and is placed between said external covering and said support.

Lighting strip generally refers to a plurality of LED, OLED, EL light sources, the relative circuits, the necessary components and the possible specific optics for possible special optical effects (uniform light, diffused light, photoluminescence, etc.). Preferably, lighting strip of LED light sources is understood here to identify that which is normally identified with the term LED strips, i.e. strips of LEDs formed by a flexible printed circuit, with variable dimensions and shape yet slim, with a negligible thickness compared to the other dimensions, whereon one or more LED (light-emitting diodes) sources are mounted which are connected electrically to this printed circuit. There are moreover electric connectors (conductors) included in said strips which allow the connection of the LED strip to a source of energy or of various strips one to the other.

The covering, in accordance with the present invention, is made of a solid silicone elastomer, which can be transparent and can be possibly coloured or with additives to obtain effects such as the diffusion of the light, phosphorescence or photoluminescence, and which can be crosslinked without heat, for example by means of exposure to UV rays.

Said covering is made by means of coextrusion of said silicone elastomer, crosslinkable without heat by means of UV rays, over the heat-conductive support supporting the LED strip.

It should be noted that the silicones, also known as polysiloxanes, are polymers based on a silicon-oxygen chain containing organic functional groups (R) linked to the atoms of silicon. According to the length of the siloxane chain, its branching and the functional groups, numerous materials can be obtained with the most widely differing characteristics and the most widely varying consistency for which they are divided into classes of application: liquids, emulsions, lubricant compounds, resins and elastomers.

Crosslinkable silicone elastomer (or silicone rubber) is understood here to identify a poly(diorganosiloxane) silicone polymer made up mainly of diorganosiloxane repetitive units R₂SiO_{2/2} (R=organic group) where each atom of silicon inside the polymer chain is bound to two oxygen atoms, giving rise to substantially linear polymer chains.

This elastomer is generally amorphous and has, after the crosslinking process, elastic properties in the conditions of use such that, if subjected to tensile forces, it reaches high elongations (several times its own length) and, on removing the stress, recovers substantially, and in short lengths of time, the initial dimensions. In particular the silicone elastomers are not comparable to the silicone resins used in US 2010/277914.

The silicone resins are in fact made up mainly of repetitive units of the type R-SiO_{3/2} and/or SiO_{4/2}, where each atom of silicon is bound to three or four atoms of oxygen and contains at most an organic substituent. These are therefore branched polymers with three-dimensional structure which, after crosslinking, are rigid and do not possess the typical elasticity of the silicone elastomers. The silicone resins are processed by pouring and by moulding.

Moreover the silicone elastomer used here is typically a solid silicone elastomer, perfectly suitable for being extruded in screw extruders, for example at high pressure, and which can be crosslinked without the use of heat (cold) by means of exposure to UV rays, for example like the silicone elastomer described in the patent application WO 2009/027133, incorporated here in full by reference. Particularly suitable for being used in the present invention as covering is, for example, a silicone elastomer for extrusion produced by MOMENTIVE PERFORMANCE MATERIALS, known commercially by the name Addisil* UV 60 EX.

The heat-conductive material is also a flexible material and can be of the silicone elastomer type, or polymeric appropriately added with additives (with metals, metal oxides or with other heat-conductive additives) or be another flexible heat-conductive material. Said support is previously prepared before coextruding over said covering.

The lighting element in accordance with the present invention resulting from the coextrusion incorporates completely the lighting strip, without any intermediate space, and therefore inside it there are no air bubbles which prevent the diffusion of the light. The good light transmission of the lighting element in accordance with the invention is therefore guaranteed both by the silicone elastomer and by the process of coextrusion described above.

The covering has the purpose of protecting the lighting strip of LEDs against external agents (air, water, atmospheric agents and other various damaging chemical agents) and will likewise have the most suitable shape according to the type of final application, the optical effect it has to have and the aesthetic value required.

The heat-conductive support, also of the most suitable shape according to the type of application, has the purpose of allowing the dissipation towards the exterior of the heat generated by the lighting strip.

Moreover, according to the end use and the seat wherein said lighting elements are to be housed, they may also have hitching feet or particular slotting profiles, thus avoiding the use of double adhesives.

They may also have additional sealing and/or abutting elements which enable the use of said lighting elements as gaskets.

The lighting element of the present invention is flexible and elastic in that capable of returning into its initial shape after bending: this is made possible thanks to the combined use of only flexible, elastic and deformable components such as elastomers and LED strips of slim thickness as defined above.

Moreover thanks to the use of said flexible, elastic and deformable components the lighting element of the present invention can be appropriately bent: this is very advantageous in that its versatility of use is greater compared to the known lighting elements.

It should also be noted that the possibility of imparting any shape on the external casing of a strip of LED lights is particularly desirable in order to confer also a high aesthetic quality to the lighting element containing said strips of LEDs.

Further features of the invention will be made clearer by the following detailed description referred to some of its embodiments purely by way of a non-limiting example, illustrated in the accompanying drawings, in which:
Fig. 1 is a cross-section view of a first embodiment of the lighting element in accordance with the invention;
Fig. 1b is a perspective view of the embodiment of Fig. 1a;
Fig. 2 is a cross-section view of a second embodiment of the lighting element in accordance with the invention, which is also provided with attachment fins;
Fig. 3 is a cross-section view of a third embodiment of the lighting element in accordance with the invention;
Figs. 4 and 5 are cross-section views of the embodiment of Fig. 1 containing moreover different electric conductors for the light sources of the strip.

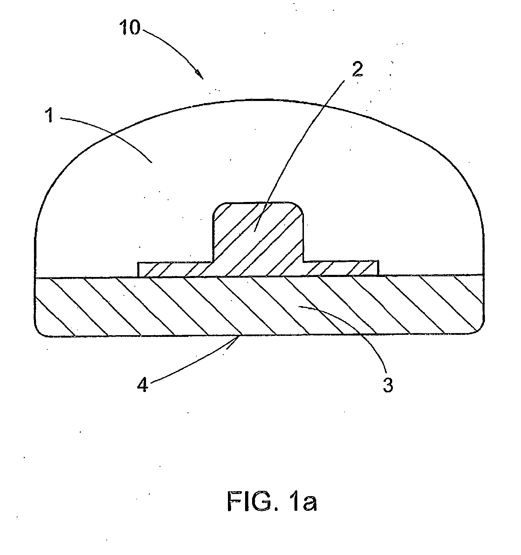

Referring to Figure 1a, a first embodiment of a lighting element of the invention is illustrated, denoted by reference numeral 10.

This element 10 has a covering body 1 having a dome profile, which incorporates centrally the lighting strip 2 containing the light sources of LED or other type. Said dome profile of the covering 1 is turned outwards.

The lighting strip 2 is placed on a support 3 in heat-conductive material. Between the element 2 and the heat-conductive support 3 it is necessary to ensure a perfect coupling, obtained mechanically and/or by means of the interposition of appropriate materials, in turn heat-conductive.

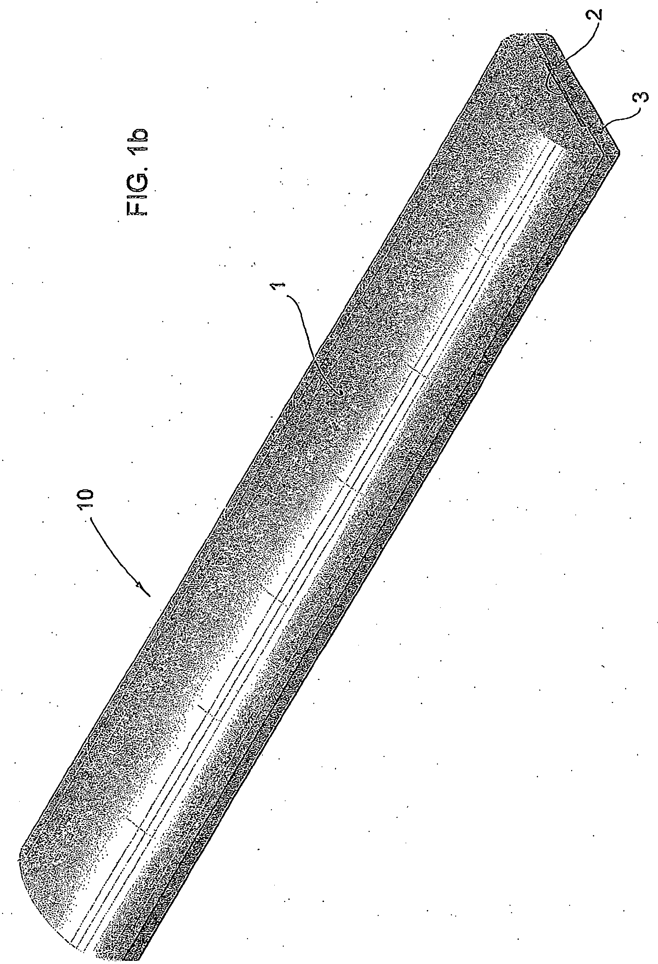

As is clear from Figure 1, the lighting strip 2 is completely embedded between the covering body 1 and the heat-conductive support 3, without any possibility of leaving a possible air pocket. This is due to the process of coextrusion, described herein below, whereby the lighting element 10 of the present invention is made, thanks to which the lighting strip is completely surrounded by the silicone material 1 and by the heat-conductive material 3.

It should be noted that the covering 1 can incorporate completely in its interior also the heat-conductive support whereon the LED strip is placed, surrounding therefore both the strip and the heat-conductive support.

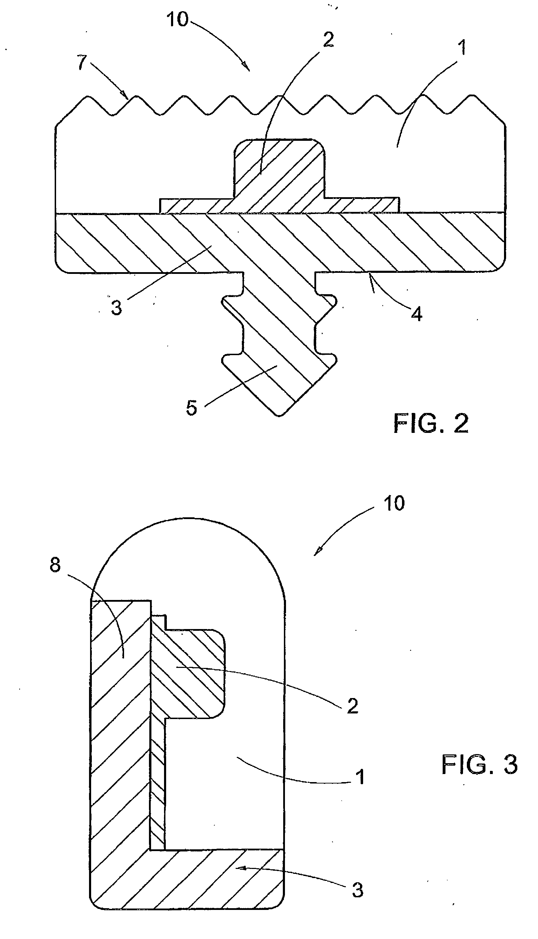

The shape of the profile of the external covering body 1 is not binding for the purposes of the present invention and can be of any shape, for example substantially rectangular in section, with a plurality of corrugations 7 on the surface as illustrated in Fig. 2. Said corrugations or fins 7 are integral with said covering 1, can be one or more, and have the function of sealing, abutting or hitching.

In the embodiment of Fig. 2, the support 3 also carries, on the back 4, one or more projecting fins 5 which are integral with said support 3, whose shape is not binding for the purposes of the present invention. The shape of said fins 5 depends substantially on the width of the seat of the section bar wherein said fin 5 has to be forcedly inserted to perform the fixing of the lighting element 10 of the present invention to the building or to another support. Said fins 5 can be one or more, and have the function of sealing, abutting or hitching.

Fig. 3 illustrates an embodiment of the present lighting element 10 wherein the heat-conductive support 3 is not rectangular but has an L shape since said lighting element 10 is intended to be fitted in a section bar or seat with L shape. The lighting strip is in contact with the elongated part 8 of the L and the body 1 has a profile complementary to said L, partially incorporating it.

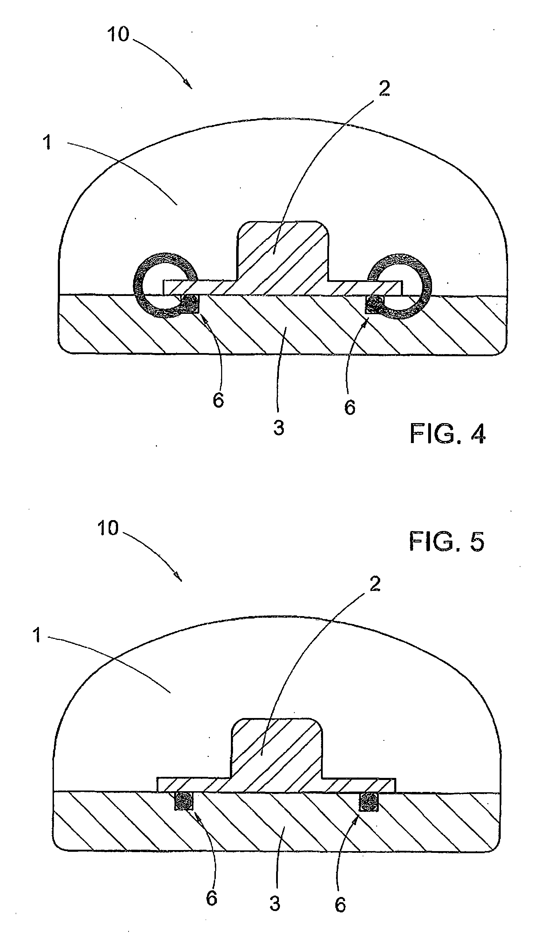

The lighting element 10 of Fig. 1 can also incorporate light sources provided with electric conductors 6, as illustrated in Figs. 4-5, in the case wherein it is necessary to have a relaunch of the electrical signal due to the length of the LED strip.

In this case the heat-conductive support 3 or the covering 1 can have one or more seats in which to house the contacts of said conductors.

In the figures the ends of the heat-conductive support 3 have been shown in contact with the ends of the covering 1, even if this is not binding for the purposes of the present invention in that it is also possible that the covering 1 incorporates completely in its interior the support 3 holding the LED strip 2, in the case wherein the latter are not high power, so as to distribute the heat over the entire covering.

The lighting elements 10, in accordance with the present invention, obtained by means of the coextrusion of a silicone elastomer, crosslinkable without heat, on a profile or support in heat-conductive material which supports a strip of light sources, may take on any section and dimension.

The silicone elastomer material which covers the light source, and which is coextruded on the heat-conductive profile (support) previously prepared, is crosslinked without heat in a few seconds by means of UV radiation exposure, at a temperature extensively compatible with all the types of light sources used.

In the case wherein the support 2 is made up of a heat-conductive silicone elastomer, said elastomer will be first extruded in the required shape and later crosslinked, with heat or without heat, in order to obtain a profile suitable for supporting the lighting strip.

It is also possible to use, during the preparation of the covering 1, additives to impart various properties, such as for example resistance to prolonged exposure to UV rays, to heat, to flame, to bacteria, to moulds, and/or with specific pigments to obtain special colour, luminous or photoluminescent effects: in this case the present process provides for a phase, before performing the phase of coextrusion, of adding of said additives to said silicone elastomer of the covering 1 crosslinkable without heat. Alternatively the same properties listed above can be imparted by means of surface treatments.

Thanks to the use of extrudable elastomeric silicone, crosslinkable without heat with UV rays, it is possible therefore to make in a continuous process highly flexible lighting elements, also transparent, provided with a heat-conductive portion, which can house internally lighting strips of various types. The Applicant has in fact found that the use of the aforesaid silicone elastomers, solid, extrudable and crosslinkable with UV rays, enables lighting elements to be obtained containing strips of LED lights which have an improved combination of properties compared to those known in the art:
- greater flexibility, elasticity and bendability,
- any length, shape and/or geometry required, wide range of temperatures of use and in various environmental situations without any deterioration,
- a high duration even when light diodes of high power are present, thanks to the heat-dissipating part made up of the incorporated heat-conductive material.

In particular the use of the aforesaid solid silicone elastomer, extrudable and crosslinkable without heat with UV rays, allows the LED strips and their conductors to be covered with a single casing, avoiding therefore the use of a second specific casing for the conductors of said LED lights and the use of double-sided adhesives for their mounting on section bar, thus reducing the probability of having damage to the LED lights incorporated and air bubbles inside the strip.

These lighting strips are suitable for being used from the minimum up to the maximum temperature of functioning of the lighting strip contained in them. For example said elastomer, crosslinkable without heat, and a heat-conductive silicone elastomer allow a wide range of temperatures of use which can range from -60°C up to +200°C.

The lack of PVC and of plasticisers also ensures the lack of hydrochloric acid fumes in the event of fire.

It is to be understood that other types of extrudable elastomers (rubbers) which can be crosslinked without heat with UV rays can also be used to make the external covering of the gasket in accordance with the present invention.

Numerous detail modifications and changes, within the reach of a person skilled in the art, may be made to the present embodiment of the invention, in any case coming within the scope of the invention disclosed by the annexed claims.

## Claims

1. Elastic and flexible lighting element (10) comprising a lighting strip (2) of LED, OLED, EL light sources covered by a single external covering (1) in solid silicone elastomer material extrudable through a screw extruder, **characterised in that** said silicone elastomer material is crosslinkable without heat by means of UV rays and **in that** said lighting strip (2) is placed between said external covering (1) and a support (3) which is in contact with said covering (1) and whereon said strip (2) rests, said support (3) being formed by a heat-conductive material which allows the dissipation of heat towards the exterior, said heat-conductive material being made up essentially of a silicone elastomer added with heat conductive additive(s) and crosslinkable with or without heat, said external covering (1) being coextruded as a continuous process over said heat-conductive support (3) which carries said lighting strip (2).

2. Element according to claim 1 wherein specific optics are present for special optical effects such as uniform light, diffused light, photoluminescence, or the like.

3. Element according to claim 1 or 2 wherein the lighting strip (2) is formed, besides the LED, OLED, EL light sources, by a printed circuit, the relative circuits, components and electric conductors (6).

4. Element according to any one of the previous claims wherein said covering (1) is transparent or coloured or with the addition of additives for obtaining effects of diffusion of the light, phosphorescence or photoluminescence.

5. Element according to any one of the previous claims wherein said external covering body (1) has a dome profile.

6. Element according to any one of the previous claims wherein said external covering body (1) has one or more projecting fins (7) integral with it, said fins being sealing, abutting or hitching elements.

7. Element according to any one of the previous claims wherein on its back (4) of the heat-conductive support (3) one or more hitching feet (5) are present, integral with said covering body (1), optionally having a shape of arrows.

8. Element according to any one of the previous claims wherein the covering (1) comprises one or more additives suitable for imparting resistance to UV rays and/or to heat and/or to flame, to bacteria, to moulds, and/or one or more pigments for obtaining chromatic effects.

9. Element according to any one of the previous claims wherein the heat-conductive support (3) is rectangular in shape or has an L-shaped section.

10. Element according to any one of the previous claims wherein said covering (1) can also completely incorporate in its interior said support (3) bearing the strip (2).

11. Process for manufacturing a flexible lighting element (10) as defined in the previous claims comprising the steps of:
- preparing a heat-conductive support (3) which allows the dissipation of heat towards the exterior, said heat-conductive support (3) being made up essentially of a silicone elastomer added with heat conductive additive(s) and crosslinkable with or without heat;
- placing a lighting strip (2) of LED, OLED, EL light sources on the heat-conductive support (3), optionally interposing suitable materials between them;
- continuously coextruding a solid silicone elastomer, crosslinkable without heat with UV rays, over said strip (2) supported by said heat-conductive support (3), so as to form the covering (1);
- crosslinking the previously coextruded covering (1) by exposure to UV rays.

## Patentansprüche

1. Elastisches und flexibles Beleuchtungselement (10), das einen Beleuchtungsstreifen (2) von LED-, OLED-, EL-Lichtquellen umfasst, die von einer einzigen externen Abdeckung (1) aus festem Silikonelastomer-Material bedeckt sind, welches durch einen Schneckenextruder extrudiert werden kann, **dadurch gekennzeichnet, dass** das Silikonelastomer-Material ohne Wärme mittels UV-Strahlen vernetzbar ist, und **dadurch gekennzeichnet, dass** der Beleuchtungsstreifen (2) zwischen der externen Abdeckung (1) und einer Abstützung (3) liegt, die sich in Kontakt mit der Abdeckung (1) befindet und worauf der Streifen (2) ruht, wobei die Abstützung (3) durch ein wärmeleitendes Material gebildet wird, das die Ableitung von Wärme nach außen ermöglicht, wobei das wärmeleitende Material im Wesentlichen aus einem Silikonelastomer hergestellt ist, das mit zugefügten wärmeleitenden Additiv(en) versehen ist und mit oder ohne Wärme vernetzbar ist, wobei die externe Abdeckung (1) in Form eines kontinuierlichen Prozesses über die wärmeleitende Abstützung (3) koextrudiert wird, die den Beleuchtungsstreifen (2) trägt.

2. Element nach Anspruch 1, wobei eine spezielle Optik für spezielle optische Effekte vorhanden ist, wie zum Beispiel gleichförmige Licht, diffuses Licht, Fotolumineszenz oder dergleichen.

3. Element nach Anspruch 1 oder 2, wobei der Beleuchtungsstreifen (2) neben LED-, OLED-, EL-Lichtquellen durch eine gedruckte Leiterplatine, die entsprechenden Schaltungen, Komponenten und elektrische Leiter (6) gebildet wird.

4. Element nach einem der vorherigen Ansprüche, wobei die Abdeckung (1) transparent oder farbig ist oder mit dem Zusatz von Additiven versehen ist, um Diffusionseffekte für das Licht, Phosphoreszenz oder Fotolumineszenz zu erhalten.

5. Element nach einem der vorherigen Ansprüche, wobei der äußere Abdeckungskörper (1) ein Kuppelprofil hat.

6. Element nach einem der vorherigen Ansprüche, wobei der äußere Abdeckungskörper (1) eine oder mehrere vorragende Rippen (7) hat, die in denselben integriert sind, wobei die Rippen abdichtende, anstoßende oder anhaftende Elemente sind.

7. Element nach einem der vorherigen Ansprüche, wobei auf seiner Rückseite (4) der wärmeleitenden Abstützung (3) ein oder mehrere Befestigungsfüße (5) vorhanden sind, die in den Abdeckungskörper (1) integriert sind, welche optional eine Form von Pfeilen haben.

8. Element nach einem der vorherigen Ansprüche, wobei die Abdeckung (1) ein oder mehrere Zusätze umfasst, welche zum Vermitteln von Beständigkeit gegenüber UV-Strahlen und/oder Wärme und/oder Bränden, Bakterien, Pilzen und/oder ein oder mehrere Pigmente zum Erhalten chromatischer Effekte geeignet sind.

9. Element nach einem der vorherigen Ansprüche, wobei die wärmeleitende Abstützung (3) rechteckig ist oder einen L-förmigen Abschnitt hat.

10. Element nach einem der vorherigen Ansprüche, wobei die Abdeckung (1) auch vollständig in sein Inneres aufgenommen sein kann, wobei die Abstützung (3) den Streifen (2) trägt.

11. Verfahren zum Herstellen eines flexiblen Beleuchtungsstreifens (10) nach einem der vorherigen Ansprüche, das die folgenden Schritte umfasst:
- Herstellen einer wärmeleitenden Abstützung (3), die das Ableiten von Wärme nach außen ermöglicht, wobei die wärmeleitende Abstützung (3) im Wesentlichen aus einem Silikonelastomer hergestellt ist, dem wärmeleitende Zusätze zugefügt sind und das mit oder ohne Wärme vernetzbar ist;
- Aufbringen eines Beleuchtungsstreifens (2) aus LED-, OLED-, EL-Lichtquellen auf die wärmeleitende Abstützung (3), wobei optional geeignete Materialien zwischen ihnen eingefügt sind;
- kontinuierlich ein festes Silikonelastomer, das ohne Wärme mit UV-Strahlen vernetzbar ist, über dem Streifen (2) coextrudieren, der durch die wärmeleitende Abstützung (3) getragen wird, um so die Abdeckung (1) zu bilden;
- Vernetzen der vorher coextrudierten Abdeckung (1) durch Einwirkenlassen von UV-Strahlen.

## Revendications

1. Elément d'éclairage élastique et flexible (10) comprenant une bande d'éclairage (2) de sources lumineuses LED, OLED, EL recouvertes d'un recouvrement externe unique (1) en matériau élastomère de silicone solide extrudable par une extrudeuse à vis, **caractérisé en ce que** ledit matériau élastomère de silicone est réticulable sans chaleur au moyen de rayons UV et **en ce que** ladite bande d'éclairage (2) est placée entre ledit recouvrement externe (1) et un support (3) qui est en contact avec ledit recouvrement (1) et sur lequel repose ladite bande (2), ledit support (3) étant constitué d'un matériau thermoconducteur qui permet la dissipation de chaleur vers l'extérieur, ledit matériau thermoconducteur étant sensiblement constitué d'un élastomère de silicone auquel sont ajoutés un ou plusieurs additifs thermoconducteurs et réticulable avec ou sans chaleur, ledit recouvrement externe (1) étant coextrudé dans le cadre d'un procédé continu sur ledit support thermoconducteur (3) qui porte ladite bande d'éclairage (2).

2. Elément selon la revendication 1, dans lequel des composants optiques spécifiques sont présents pour des effets optiques spéciaux comme une lumière uniforme, une lumière diffuse, une photoluminescence ou d'autres effets similaires.

3. Elément selon la revendication 1 ou 2, dans lequel la bande d'éclairage (2) est constituée, en plus des sources lumineuses LED, OLED, EL, d'un circuit imprimé, de circuits relatifs, de composants et de conducteurs électriques (6).

4. Elément selon l'une quelconque des revendications précédentes, dans lequel ledit recouvrement (1) est transparent, de couleur ou complété d'additifs pour obtenir des effets de diffusion de lumière, une phosphorescence ou une photoluminescence.

5. Elément selon l'une quelconque des revendications précédentes, dans lequel ledit corps de recouvrement externe (1) a un profil en dôme.

6. Elément selon l'une quelconque des revendications précédentes, dans lequel ledit corps de recouvrement externe (1) a une ou plusieurs ailettes saillantes (7) faisant partie intégrante de celui-ci, lesdites ailettes étant des éléments de scellement, de butée ou d'accrochage.

7. Elément selon l'une quelconque des revendications précédentes, dans lequel, au dos (4) du support thermoconducteur (3), il est présent un ou plusieurs pieds d'accrochage (5) faisant partie intégrante dudit corps de recouvrement (1), ayant facultativement une forme de flèches.

8. Elément selon l'une quelconque des revendications précédentes, dans lequel le recouvrement (1) comprend un ou plusieurs additifs aptes à appliquer une résistance aux rayons UV et/ou une chaleur et/ou une flamme, des bactéries, des moisissures, et/ou un ou plusieurs pigments pour obtenir des effets chromatiques.

9. Elément selon l'une quelconque des revendications précédentes, dans lequel le support thermoconducteur (3) est de forme rectangulaire ou de coupe en forme de L.

10. Elément selon l'une quelconque des revendications précédentes, dans lequel ledit recouvrement (1) peut également incorporer complètement ledit support (3) portant la bande (2) à l'intérieur de celui-ci.

11. Procédé de fabrication d'un élément d'éclairage flexible (10) selon les revendications précédentes, comprenant les étapes de :
- la préparation d'un support thermoconducteur (3) qui permet la dissipation de chaleur vers l'extérieur, ledit support thermoconducteur (3) étant sensiblement constitué d'un élastomère de silicone auquel sont ajoutés un ou plusieurs additifs thermoconducteurs et réticulable avec ou sans chaleur ;
- le placement d'une bande d'éclairage (2) de sources lumineuses LED, OLED, EL sur le support thermconducteur (3), en interposant facultativement des matériaux appropriés entre celles-ci ;
- la coextrusion continue d'un élastomère de silicone solide, réticulable sans chaleur avec des rayons UV, sur ladite bande (2) supportée par ledit support thermoconducteur (3) de manière à constituer le recouvrement (1) ;
- la réticulation du recouvrement préalablement coextrudé (1) par exposition à des rayons UV.
